Europäisches Patentamt

European Patent Office

Office européen des brevets

(11) Publication number: **0 177 302**
A2

## (12) EUROPEAN PATENT APPLICATION

(21) Application number: 85306908.6

(22) Date of filing: 27.09.85

(51) Int. Cl.⁴: **G 03 F 7/02**
**B 41 N 1/12, G 03 F 7/16**

(30) Priority: 28.09.84 US 655857

(43) Date of publication of application:
09.04.86 Bulletin 86/15

(84) Designated Contracting States:
BE DE FR GB IT NL SE

(71) Applicant: HERCULES INCORPORATED
Hercules Plaza
Wilmington Delaware 19894(US)

(72) Inventor: Schroeder, Richard Basil
610 Cheltenham Road Westminster
Wilmington Delaware 19808(US)

(74) Representative: De Minvielle-Devaux, Ian Benedict
Peter et al,
CARPMAELS & RANSFORD 43, Bloomsbury Square
London WC1A 2RA(GB)

(54) Compressable printing plate.

(57) A process of preparing compressible printing plates by casting a liquid photopolymer composition on a negative, placing a compressible backing sheet over the liquid photopolymer, exposing through the backing sheet, imaging through the negative and developing.

This invention relates to a process of preparing compressible flexographic printing plates from photopolymerizable compositions, in which a photopolymerizable layer is laminated to a compressible backing sheet, and to such flexographic printing plates having compressible backing sheets.

Printing plates prepared from polymeric materials have long been known. For example, U.S. Patent No. 2,760,863 to Plambeck discloses processes of preparing printing plates directly by exposing to actinic light through an image-bearing transparency onto a layer of photopolymer composition supported on a suitable substrate or backing sheet. The unpolymerized material is then removed, as by washing with a suitable solvent, resulting in a raised relief image that corresponds to the transparent image areas of the transparency and that is suitable for use as a printing plate.

More recently, processes have become known for preparing printing plates from liquid photopolymer compositions, where the compositions are exposed from both the front and back. For example, U.S. Patent No. 3,848,998 to Yonekura, et al, describes apparatus and a process for preparing printing plates in which a liquid photopolymeric composition is exposed from both sides. The advantages of exposing from the back as well as the front is to promote better adhesion of the photopolymeric composition to the backing sheet, and to overcome oxygen inhibition of polymerization, particularly near the base of the relief structure, preventing under-cutting of the relief structures and producing tapered relief structures.

The above-described printing plates are all solid and substantially noncompressible. However, when printing on uneven substrates such as corrugated box stock or when using presses with low accuracy in the press cylinders, a compressible plate is desirable. Compressibility also reduces wear caused by mechanical shock on the plate.

To provide compressibility, the most obvious technique is to use a plate of low hardness. This approach, however, leads to undesirable face expansion of the relief characters during printing, particularly when using presses with low accuracy in the press cylinder.

Another technique is to adhere adhesive-backed foam tapes to the backs of previously formed printing plates. However, it is difficult to position the tapes and adhesion between the tapes and the plates is poor. In addition, the tapes are not dimensionally stable.

Still another technique is disclosed in Uniroyal's European Patent Application No. 82 300478.3, Publication No. 0057593, in which the back of a layer of photosensitive material, which is presumably dimensionally stable, is exposed to ultraviolet light, the carrier backing (if used) is removed, and a layer of foam that has been laminated with adhesive to a polyester sheet is adhesively laminated to the the back of the photosensitive material. The front of the photosensitive material then can be exposed through an image bearing transparency and developed by washing with a solvent. The technique is awkward, unsuitable for commercial plate making machinery, and involves a multiplicity of steps.

According to the invention, compressible flexographic printing plate materials can be conveniently prepared on commercial plate making machinery by a process in which a photopolymerizable layer is exposed to light from the back to harden the adjacent surface of the photopolymerizable material, and in which a compressible backing layer, com- prising a foam having a thickness uniformity within $\pm$ 127 micrometers and a thickness of from about 254 to about 2450 micrometers, is laminated to the photopolymerizable layer, the process being characterized in that the compressible backing layer comprises a translucent, microcellular foam having essentially uniform cells less than about 10 mils micrometers in diameter, and a

0177302

density of from about 10 to about 50 pounds per cubic foot, and the back of the photo- polymerizable material is exposed through both the polymeric film and the compressible backing layer, to provide a printing plate for front exposure through a negative.

Preferably, the process according to the invention is combined with with the imaging step in a continuous operation, and includes the steps of positioning a negative of the image to be printed on a transparent horizontal surface disposed above a light source, covering the negative with a protective sheet of transparent film, spreading a layer of liquid photo-polymerizable material over the protective sheet, covering the liquid material with a compressible backing layer comprising a transparent polymeric film adhered to either side of the translucent, microcellular foam layer, and exposing the liquid photopolymerizable material through the backing layer.

The photopolymerizable material is then exposed through the negative to actinic light to selectively polymerize parts of the liquid photopolymerizable material, the protective sheet is removed, and a raised relief image is produced by removing unpolymerized material.

Alternately, the steps of the preferred process according to the invention can be carried out in reverse order, starting with the combination backing layer of foam and polymeric film, in either order, at the bottom. The liquid photopolymerizable material is then spread on the backing layer, and the liquid photopolymerizable material is covered with a protective sheet. A negative can then be positioned over the protective sheet and the top of the plate exposed.

The process according to the invention may include the step of covering the backing layer on the side that will contact the photopolymerizable material with a layer of adhesive from about .05 to about 1.0 mils thick. The adhesive is particularly desirable if the photopolymerizable material is allowed to harden before the backing layer is applied.

Also according to the invention, a compressible flexographic printing plate comprising a photopolymerizable layer that has one surface hardened by exposure to light and has that surface laminated to a compressible backing layer comprising a foam having a thickness uniformity within $\pm$ 127 micrometers and a thickness of from about 254 to about 2450 micrometers, is characterized in that the foam is a translucent, microcellular foam having essentially uniform cells less than about 10 mils micrometers in diameter, and a density of from about 10 to about ·50 pounds per cubic foot.

Preferably, the compressible flexographic printing plate according to the invention has a compressible backing layer comprising a foam having a UV transmission of at least about 1%, most preferably at least 5%.

Any of the well-known liquid photopolymerizable compositions used to prepare flexographic printing plates can be used in the process of this invention. For example, U.S. Patent No. 3,794,494 to Kai et al discloses liquid photopolymerizable compositions containing an unsaturated polyester, an ethylenically unsaturated monomer and a photopolymerization initiator, which can be used as the liquid photopolymerizable composition in the process of this invention. Another example of liquid photopolymerizable compositions that can be used in the process of this invention, comprising polyester-polyether block polymers, is disclosed in U.S. Patent No. 3,960,572 to Ibata, et al. Another example of liquid photopolymerizable compositions that can be used in the process of this invention is disclosed in U.S. Patent No. 4,442,302 to Pohl. These compositions comprise a chain extended, liquid, terminally olefinically unsaturated polymer, at least one ethylenically unsaturated monomer and a photoinitiator. Many other photopolymerizable compositions can be used in the process of this invention.

It may be desirable in certain instances to use more than one layer of liquid photopolymerizable compositions and this is readily possible in the process of this invention. For example, U.S. Patent No. 4,266,007 to Hughes, et al. describes a process for making printing plates using multilayers of photopolymerizable compositions where the different layers have moduli differing by at least about 50 psi. In other words, the plates may have a harder outer layer with a softer inner layer or vise versa. It may also be desirable that the multilayers have the same hardness but different photospeeds. These multilayer plates can readily be made using the process of this invention. U.S. Patent No. 4,332,873 to Hughes, et al. also describes a process for preparing multilayer printing plates that may also be used in the process of this invention.

The protective sheet that separates the negative from the liquid photopolymerizable material can be of any transparent film material that will not adhere to either the negative or the photopolymerizable material after it is exposed and can include materials that dissolve in the aqueous developer. It will be obvious to those skilled in the art that the purpose of the protective sheet is to protect the negative from the liquid photopolymerizable material and to facilitate its removal after exposure. Typical films that may be used as protective sheets in the process of this invention are polypropylene, polyethylene, polyester, cellulose acetate and polystyrene having a thickness of about 0.25 mil to about 2.5 mils.

The compressible backing layer used in the process of this invention, which comprises a compressible translucent foam layer and a transparent polymer film layer, as already indicated may have an adhesive layer. Any adhesive that is transparent and will strongly adhere the backing sheet to the photopolymerizble material can be used. The adhesive should maintain its adhesive properties for a long period. Typical of such adhesives that can be used in the process of this invention are the polyurethane dry film adhesives.

As indicated above, the compressible foam layer should have essentially uniform cells, most preferably closed cells, less than about 10 mils in diameter, a density of from about 160 to about 800 , most preferably from about 240 to about 640, kilograms per cubic meter, a thickness uniformity within plus or minus 127 micrometers, most preferably plus or minus 38 micrometers, and a thickness of from about 254 to about 2450 micrometers, and a UV transmission of at least about 1%, most preferably at least 5%. Any compressible, translucent, microcellular foam having the above properties can be used in the process of this invention. Typical foams that can be used are polyurethane foams, polyolefin foams, polyvinyl chloride foams, rubber foams and the like. The foams can be chemically blown or mechanically frothed with any gas, including air, that will not interfere with the process of this invention nor detract from the desired properties of the foam.

The foam layer is adhered to a solid transparent noncompressible polymeric film to form the backing layer. Any polymeric film that is transparent, solid, noncom- pressible and adherent to the foam layer can be used. Typical polymeric films that can be used are polystyrene, polyvinyl chloride, polyvinyl acetate, and polyester films. Most desirably, the polymeric film will be a polyester film, such as Mylar. The foam layer can be adhered to the polymeric film by any one of several methods, such as casting the foam on the film or using adhesives.

Generally, the foam layer of the backing sheet will be adhered to the photopolymerizable material with the noncompressible polymeric film on the outside. However, it may be desirable in certain instances to place the noncompressible polymeric film in between the foam layer and photopolymerizable material. The advantages of such configurations are greater plate flexibility, less print length distortion, etc.

In those cases where the photopolymerizable material is to be adhered to the polymeric film of the backing sheet, the adhesive layer, if one is used, will be placed on the polymeric film rather than the foam layer.

Fig. 1 is a partial cross-sectional view of a printing plate with the photopolymerizable material adhered to the foam layer of the backing sheet.

Fig. 2 is a partial cross-sectional view of a printing plate with the photopolymerizable material adhered to the polymeric film of the backing sheet.

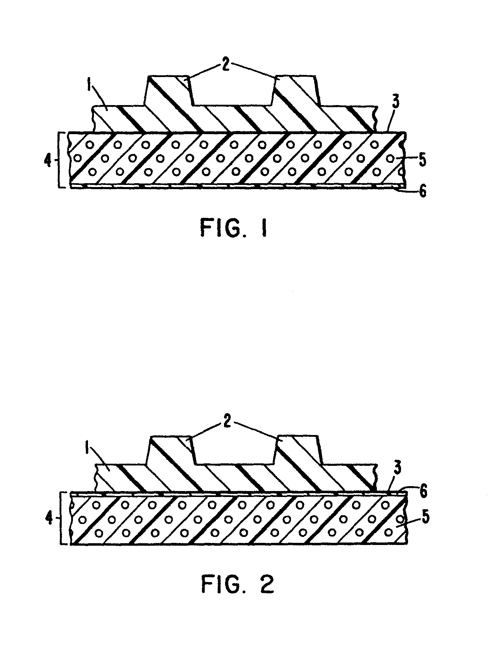

With reference to the drawing, Fig. 1 illustrates a partial cross-sectional view through a printing plate prepared in accordance with one embodiment of the process of this invention. The topmost layer 1 is the photopolymerizable material hardened by exposure to actinic light, having the unexposed material removed to leave the raised image 2. The topmost layer 1 is adhered through a thin adhesive layer 3 to the foam layer 5 of a backing sheet 4, said backing sheet 4 comprising the thin adhesive layer 3, the foam layer 5 and on the bottom a polymeric film 6. Fig. 2 illustrates a partial cross-sectional view through a printing plate prepared in accordance with another embodiment of the process of this invention. The topmost layer 1 is the photopolymerizable material hardened by exposure to actinic light, having the unexposed material removed to leave the raised image 2. The topmost layer 1 is adhered through a thin adhesive layer 3 to the polymeric film 6 of a backing sheet 4, said backing sheet 4 comprising the thin adhesive layer 3, the polymeric film 6, and on the bottom a foam layer 5.

Printing plates of varying thicknesses can be prepared using the process of this invention. In general, the printing plates can range from about 20 mils up to about 250 mils. The photopolymerizable layer will generally range from about 5 mils to about 200 mils, most preferably from about 10 mils to about 150 mils. The foam layer will generally range from about 10 mils to about 100 mils, most preferably from about 10 mils to about 60 mils. The polymeric film will generally be about 2 mils to about 15 mils and the adhesive layer, if one is used, will generally be about 0.05 to about 1.0 mils.

Any of the well-known commercial exposure units that can expose from both sides can be used in the process of this invention. The specific exposure conditions will depend upon the specific liquid photopolymerizable material used, the thickness and composition of the foam layer and the like. However, in general exposure units capable of emitting light in wave lengths of from about 300 to about 400 nanometers and having intensities of from about 1 to about 10 milliwatts per square centimeter can be used.  Exposure through the backing sheet as well as directly to the photopolymerizable material through the negative will generally be for a period of time of from about 10 seconds to about 15 minutes.  A typical commercial exposure unit that can be used in the process of this invention is the Merigraph$^R$ 3040 exposure unit sold by Hercules Incorporated.

Unexposed liquid unpolymerized material can be removed to produce a raised relief image by several different methods. For example, it can be washed away, it can be blown away using an air knife, it can be blotted away, or squeegeed away or a combination of two or more of the above methods can be used. Most preferably, the unpolymerized material will be washed or dissolved away using one of the commercial developer units.

Any commercial developer unit that employs developer solutions can be used to develop the printing plates of this invention.  The specific solution used will depend upon the specific photopolymerizable material used to make the plate and will be obvious to those skilled in the art.  Generally, an aqueous alkaline solution will be used.  It may also be desirable to employ a small amount of detergent or surface active agent in the aqueous developing solution.  In the case of some photopolymer compositions, it may be necessary to post-cure the plates after development to get rid of surface tackiness.  This presents no problem since the plates of this invention can be processed just the same as noncompressible plates.

The following examples will further illustrate the invention.  Parts and percentages are by weight unless indicated otherwise.

## Example 1

A graphic arts negative is positioned on a horizontal glass plate and a thin protective film of polypropylene is placed over the negative.

A liquid photopolymer is prepared exactly as described in Example No. 2 of U.S. Patent No. 4,442,302 and doctored on the film covered negative to a thickness of 75 mils.

A compressible backing sheet is prepared by coating one side of a closed cell microcellular sheet of 29 mil polyurethane foam having skin on both sides, essentially uniform cells less than 0.1 mil in diameter and a density of 30 pounds per cubic foot, with an approximately 2 mil layer of acrylic transfer adhesive and then adhering to the adhesive layer a 4 mil polyester sheet. The resulting translucent backing sheet transmits approximately 5% of UV light.

The backing sheet is placed over the liquid photopolymer with the foam side next to the photopolymer. The resulting laminate is exposed from above through the backing sheet for 6 minutes to UV light, 4 milliwatts/cm$^2$. Then the laminate is exposed from the bottom through the glass late for 2 minutes to UV light, 4 milliwatts/cm$^2$. The exposed lami- nate is lifted off of the negative and the protective film is peeled off and discarded. The laminate is then washed with a 0.5% aqueous solution of olefin sulfonate for 6 minutes using jets of the detergent at 110°F and under a pressure of 50 p.s.i. The resulting plate is post exposed by placing it in water and exposing the raised image surface to UV light 2 miliwatts/cm$^2$ for 5 minutes. The plate is dried using forced air at a temperature of 110°F.

A printing plate with the desirable configuration of the raised image is produced, which performed well on a lab printing press.

Example 2

Another printing plate is prepared exactly as described in Example 1 except that in place of the photopolymer composition recited in Example 1 the composition described in Example 3 of U.S. Patent No. 3,960,572 is used. Again, a printing plate with the desirable configuration of the raised image is produced, which performs well on a lab printing press.

### Examples 3 to 7

These examples illustrate the preparation of printing plates of various thicknesses.

Backing sheets 40, 50 and 60 mils in total thickness are prepared having various thickness of closed cell microcellular sheets of polyurethane foam having a skin on both sides, essentially uniform cells less than 0.1 mil in diameter and a density of 30 pounds per cubic foot and 4 mil polyester sheets by casting the liquid polyurethane and foaming it on the polyester sheet. The resulting backing sheets have a thickness uniformity within plus or minus 1.5 mils and transmit approximately 5, 4 and 3% of UV light as the thickness of the sheets increases. Each sheet is coated with approximately 0.25 mil of polyurethane dry film adhesive.

Printing plates 67 and 110 mils in total thickness are prepared using the photopolymer composition described in Example No. 5 of U.S. Patent No. 4,442,302.

Each plate is prepared according to the procedure recited in Example 1. The thickness of the backing sheets, photopolymer layers and exposure time through the foam (back exposure) and through the glass plate (front exposure) is tabulated below.

| 67 mil Printing Plate | Example 3 | Example 4 |
|---|---|---|
| Backing Sheet (mils) | 41.5 | 51.5 |
| Photopolymer Layer (mils) | 25.5 | 15.5 |
| Back Exposure (minutes) | 6 | 6 |
| Front Exposure (minutes) | 2 | 2 |

| 110 mil Printing Plate | Example 5 | Example 6 | Example 7 |
|---|---|---|---|
| Backing Sheet (mils) | 41.5 | 51.5 | 61.5 |
| Photopolymer Layer (mils) | 68.5 | 58.5 | 48.5 |
| Back Exposure (minutes) | 8 | 12 | 15 |
| Front Exposure (minutes) | 4 | 3 | 2 |

The resulting printing plates are measured for uniformity, the letters are examined for shoulder angle and the adhesion of the photopolymer layer to the backing sheets is checked and all are found to be satisfactory for printing applications.

## Examples 8 and 9

Two printing plates are prepared in accordance with the procedure described in Example 1. A 50 mil backing sheet comprising 0.25 mil of polyurethane dry film adhesive, a 4 mil polyester film and a 44.5 mil closed cell microcellular sheet of polyurethane foam having skin on both sides, essentially uniform cells less than 0.1 mil in diameter and a density of 30 pounds per cubic foot is used in each plate. The backing sheets transmit approximately 4% of UV light. On the foam side of one backing sheet is doctored 60 mils of the photopolymer composition described in Example 1 and on the foam side of the other backing sheet is doctored 60 mils of the photopolymer describes in Examples 3-7. Each plate is exposed 12 minutes through the foam and 3 minutes through the glass plate, developed, post exposed and dried as described in Example 1. Each plate is mounted on a 12 inch Manhasset laboratory printing press and run at 240 r.p.m. using an alcohol base ink and printing on polyethylene film. After printing over 4800 copies, the print is still clear and the plates in excellent condition.

1. A process for making a compressible flexographic printing plate in which a photopolymerizable layer is exposed to light from the back to harden the adjacent surface of the photopolymerizable material, and in which a compressible backing layer, comprising a foam having a thickness uniformity within ± 127 micrometers and a thickness of from about 254 to about 2450 micrometers, is laminated to the photopolymerizable layer, characterized in that the com- pressible backing layer comprises a translucent, microcellular foam having essentially uniform cells less than about 10 mils micrometers in diameter, and a density of from about 160 to about 800 kilograms per cubic meter, and the back of the photopolymerizable material is exposed through both the polymeric film and the compressible backing layer, to provide a printing plate for front-exposure through a negative.

2. A process for making a printing plate as claimed in claim 1, further characterized in that it includes the steps of positioning a negative of the image to be printed on a transparent horizontal surface disposed above a light source, covering the negative with a protective sheet of transparent film, spreading a layer of liquid photopolymerizable material over the protective sheet, covering the liquid material with a compressible backing layer comprising a transparent polymeric film adhered to the translucent, microcellular foam layer, and exposing the liquid photopolymerizable material through the backing layer.

3. A process for making a printing plate as claimed in claim 2, further characterized in that it includes the steps of exposing the photopolymerizable material through the negative to actinic light to selectively polymerize parts of the liquid photopolymerizable material, removing the negative and the protective sheet, and removing unpolymerized material to produce a raised relief image.

4. A process for making a printing plate as claimed in claim 2, further characterized in that it includes the steps of positioning the combination backing layer of foam and polymeric film on a transparent horizontal surface disposed above a light source, spreading liquid photopolymerizable material on the backing layer, and covering the photopolymerizable material with a protective sheet of transparent film.

5. A process for making a printing plate as claimed in claim 4, further characterized in that it includes the steps of positioning a negative over the protective sheet, exposing the top of the plate, removing the the negative and the protective sheet, and removing unpolymerized material to produce a raised relief image.

6. A compressible flexographic printing plate comprising a photopolymerizable layer that has one surface hardened by exposure to light and has that surface laminated to a compressible backing layer comprising a foam having a thickness uniformity within ± 127 micrometers and a thickness of from about 254 to about 2450 micrometers, characterized in that the foam is a translucent, microcellular foam having essentially uniform cells less than about 254 micrometers in diameter, and a density of from about 160 to about 800 kilograms per cubic meter.

7. A compressible flexographic printing plate as claimed in claim 6, further characterized in that the foam has a UV transmission of at least about 1%.

8. A compressible flexographic printing plate as claimed in claim 7, further characterized in that the foam has a UV transmission of at least 5%.

FIG. 1

FIG. 2